Europäisches Patentamt

European Patent Office

Office européen des brevets

(19)

(11) Numéro de publication : **0 157 686**
**B1**

(12)
# FASCICULE DE BREVET EUROPÉEN

(45) Date de publication du fascicule du brevet :
**02.03.88**

(21) Numéro de dépôt : **85400503.0**

(22) Date de dépôt : **15.03.85**

(51) Int. Cl.⁴ : **C 30 B  15/00, C 23 C   2/40**

(54) **Dispositif pour déposer une couche de silicium sur un ruban de carbone.**

(30) Priorité : **16.03.84 FR 8404074**

(43) Date de publication de la demande :
**09.10.85 Bulletin 85/41**

(45) Mention de la délivrance du brevet :
**02.03.88 Bulletin 88/09**

(84) Etats contractants désignés :
**AT BE CH DE FR GB IT LI LU NL SE**

(56) Documents cités :
**FR-A- 2 386 359**

(73) Titulaire : **COMPAGNIE GENERALE D'ELECTRICITE**
**Société anonyme dite:**
**54, rue La Boétie**
**F-75382 Paris Cedex 08 (FR)**

**SOCIETE NATIONALE ELF AQUITAINE**
**Tour Aquitaine - Cédex 4**
**F-92080 Paris la Défense (FR)**

(72) Inventeur : **Belouet, Christian**
**138 rue Houdan**
**F-92330 Sceaux (FR)**

(74) Mandataire : **Weinmiller, Jürgen et al**
**Lennéstrasse 9 Postfach 24**
**D-8133 Feldafing (DE)**

## Description

La présente invention concerne un dispositif pour déposer une couche de silicium sur un ruban de carbone, ce dispositif étant d'un type comportant

— un récipient muni d'un fond horizontal dans lequel est ménagée une fente le traversant, le profil horizontal de la fente comprenant deux segments de droite opposés et parallèles entre eux, ces segments délimitant une surface rectangulaire dont la longueur correspond aux segments, un ruban traversant la fente de manière que la largeur du ruban soit parallèle aux segments,

— des moyens pour disposer dans le récipient un bain de silicium liquide

— et des moyens pour tirer verticalement le ruban, de bas en haut, dans le sens de sa longueur, de façon à déposer ladite couche, la largeur de ladite surface rectangulaire étant suffisamment faible pour que le ménisque de silicium reliant le ruban aux parois de la fente soit stable.

Un dispositif connu de ce type est décrit dans le document FR-A-2 386 359. Dans ce dispositif, la fente a une section horizontale rectangulaire dont la longueur est légèrement supérieure à la largeur du ruban, et dont la largeur est légèrement supérieure à l'épaisseur du ruban. A titre indicatif, pour un ruban de largeur 50 mm et d'épaisseur 0,3 mm, la section rectangulaire de la fente a une longueur de 50,4 mm et une largeur de 0,6 mm.

Un tel dispositif présente un inconvénient. En effet, pour éviter le blocage et l'arrachage du ruban dans la fente au cours du tirage, il est nécessaire de prévoir des tolérances très serrées sur la largeur et l'alignement du ruban ainsi que sur la direction de tirage. Il est à noter par ailleurs que le ruban comporte en général un mince revêtement protecteur en pyrocarbone : en cas d'arrachage de ce revêtement, l'âme en carbone ordinaire du ruban présente une forte réactivité avec le silicium liquide.

La présente invention a pour but de pallier cet inconvénient.

Elle a pour objet un dispositif pour déposer une couche de silicium sur un ruban de carbone, du type mentionné ci-dessus, caractérisé en ce que

— la paroi de la fente est arrondie vers l'extérieur, du côté de la face inférieure du fond,

— la longueur des segments est égale à la largeur du ruban

— et le profil horizontal de la fente comprend en outre deux courbes circulaires délimitant deux surfaces circulaires disposées respectivement aux deux extrémités de ladite surface rectangulaire, chacune de ces surfaces circulaires étant centrée sur l'axe longitudinal de la surface rectangulaire, les courbes circulaires se raccordant avec les extrémités des segments, de manière que les surfaces circulaires soient en communication avec la surface rectangulaire, le diamètre des surfaces circulaires étant supérieur à la largeur de ladite surface rectangulaire et inférieur à une valeur prédéterminée correspondant au diamètre maximal capable d'assurer la stabilité du ménisque de silicium.

Une forme particulière d'exécution de l'objet de la présente invention est décrite ci-dessous à titre d'exemple, en référence aux dessins annexés dans lesquels

— la figure 1 représente schématiquement un dispositif selon l'invention pour déposer une couche de silicium sur un ruban de carbone,

— la figure 2 est une vue agrandie en coupe verticale d'une fente ménagée dans le fond d'un récipient faisant partie du dispositif illustré par la figure 1

— et la figure 3 est une vue en coupe horizontale de la fente illustrée par la figure 2.

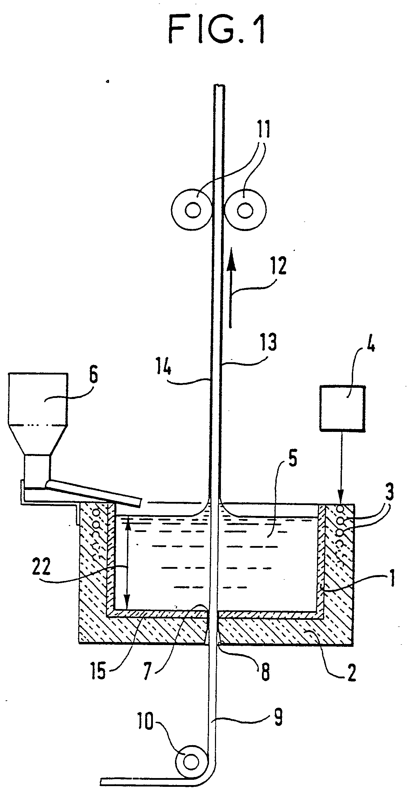

Sur la figure 1, est visible, en coupe verticale, un récipient 1 en quartz dont les parois sont entourées par un four électrique 2. Les résistances 3 du four 2 sont connectées à une source de courant électrique 4. Le récipient 1 contient un bain 5 de silicium liquide, ce bain étant alimenté en pastilles de silicium solides à l'aide d'un réservoir 6 muni d'organes de distribution.

Le fond horizontal 15 du réservoir 1 comporte une fente 7 et le fond du four 2 est muni d'une ouverture 8 en regard de la fente 7. Un ruban de carbone 9 est glissé à travers la fente 7 et l'ouverture 8 de façon à traverser verticalement le bain de silicium 5. La figure représente le réservoir 1 coupé par un plan perpendiculaire au ruban 9 sensiblement au milieu de la longueur de la fente 5. Des rouleaux tels que 10 et 11 permettent de tirer le ruban de bas en haut dans le sens de sa longueur suivant la flèche 12. Après passage dans le bain 5, le ruban de carbone 9 est recouvert sur ses deux faces de deux couches de silicium 13 et 14. Ces couches peuvent être séparées du substrat de carbone puis découpées de façon à obtenir des plaquettes de silicium capables d'être utilisées pour la fabrication de cellules photoélectriques solaires.

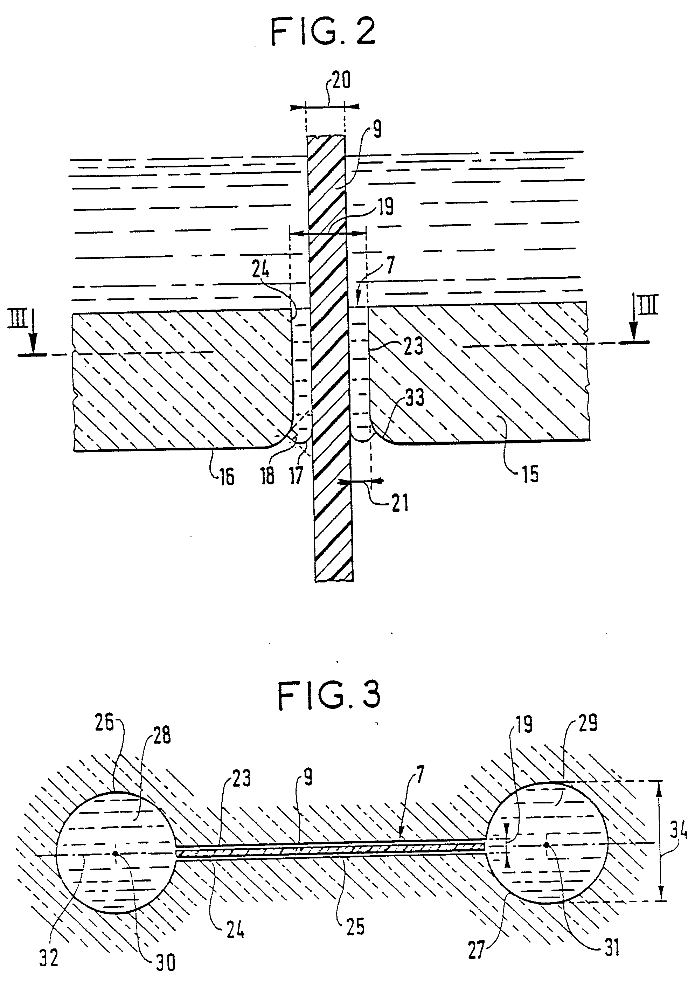

La figure 2 est une vue agrandie de la fente 7. Elle montre les parois 23 et 24 de la fente, généralement verticales, mais présentant une partie 33 arrondie vers l'extérieur de la fente. Cette partie arrondie est située du côté de la face inférieure 16 du fond 15 du récipient. Grâce à cette disposition, le ménisque 17 de silicium fondu reliant les parois de la fente au ruban 9 présente, par rapport à la surface arrondie de la fente, un angle de raccordement 18 sensiblement égal à 90°, ce qui est favorable à la stabilité du ménisque. Néanmoins, la différence entre la largeur 19 de la fente 7 et l'épaisseur 20 du ruban, dans la partie de la fente illustrée par la figure 2, doit être inférieure à un écart maximum admissible relativement faible ; en effet il est nécessaire de réduire le jeu moyen 21 entre le ruban et les parois de la fente, pour assurer avec une marge de sécurité convenable la stabilité du ménisque 17 et éviter les fuites de silicium liquide. La largeur de la fente est prédéterminée en fonction de l'épaisseur du ruban et de la hauteur 22 du bain 5 de silicium. A titre indicatif, pour une hauteur de bain de deux centimètres et une épaisseur de 0,3 mm du ruban, le récipient 1 étant en quartz, la largeur 19 de la fente peut être de 0,6 mm.

La figure 3 est une section de la fente 7 par un plan horizontal III-III (figure 2) coupant les parois verticales de la fente. On voit sur la figure 3 que le profil de la fente 7 comporte deux segments de droite 23 et 24 opposés et parallèles entre eux, ces segments délimitant une surface rectangulaire 25 dont la longueur correspond aux segments 23 et 24. La longueur des segments 23 et 24 est égale à la largeur du ruban 9. Celui-ci traverse la surface rectangulaire 25 de manière que, dans le plan de la figure 3, les lignes représentant les faces principales du ruban 9 soient parallèles et opposées aux segments 23 et 24.

Le profil de la fente 7 comporte en outre deux courbes circulaires 26 et 27 délimitant respectivement deux surfaces circulaires 28 et 29 disposées aux deux extrémités de la surface rectangulaire 25. Ces surfaces sont centrées en des points 30 et 31 situés sur l'axe longitudinal 32 de la surface rectangulaire 25, en dehors de cette surface. Les courbes circulaires 26 et 27 se raccordent avec les extrémités des segments 23 et 24, de sorte que les surfaces circulaires 28 et 29 sont en communication avec la surface rectangulaire 25. Les surfaces circulaires 28 et 29 ont de préférence des aires identiques et leur diamètre 34 est au moins égal à la largeur 19 de la surface circulaire 25.

Le diamètre 34 est inférieur à une valeur limite prédéterminée. Cette valeur limite correspond au diamètre maximal d'une ouverture circulaire ménagée dans le fond d'un creuset contenant un bain de silicium liquide, cette ouverture étant capable d'assurer la stabilité du ménisque de silicium reliant entre eux les bords de l'ouverture circulaire. Bien entendu, ce creuset est réalisé avec le même matériau que le récipient 1 et le niveau du bain qu'il contient correspond à la hauteur 22 du silicium liquide dans le récipient 1. Bien que cela puisse apparaître surprenant, le diamètre maximal de cette ouverture circulaire est très supérieur à l'écart maximal admissible, mentionné plus haut, entre la largeur 19 de la surface rectangulaire 25 et l'épaisseur 20 du ruban 9. Il doit être noté à ce sujet que si on choisit un diamètre d'ouverture circulaire très petit, il est difficile d'arrondir la partie inférieure des parois de la fente, ce qui entraîne alors une instabilité du ménisque.

A titre indicatif, une ouverture circulaire de diamètre deux millimètres dans le fond d'un récipient en quartz peut supporter sans fuite un bain de silicium liquide de deux centimètres de hauteur.

Dans le cas de l'exemple numérique donné plus haut, le diamètre 34 des surfaces circulaires de la fente 7 peut donc avoir une valeur de deux millimètres, ce qui représente plus de trois fois la largeur (0,6 millimètre) de la surface rectangulaire 25.

Le dispositif selon l'invention présente, par rapport au dispositif connu mentionné plus haut, les avantages suivants : il permet d'admettre des tolérances accrues sur la rectitude et la largeur du ruban de carbone, ainsi que sur la direction de tirage du ruban ; tout risque de blocage ou d'arrachage du ruban sur les bords de la fente en cours de tirage sont supprimés.

**Revendications**

1. Dispositif pour déposer une couche de silicium sur un ruban de carbone, comportant

— un récipient muni d'un fond horizontal dans lequel est ménagée une fente le traversant, le profil horizontal de la fente comprenant deux segments de droite opposés et parallèles entre eux, ces segments délimitant une surface rectangulaire dont la longueur correspond aux segments, un ruban traversant la fente de manière que la largeur du ruban soit parallèle aux segments,

— des moyens pour disposer dans le récipient un bain de silicium liquide

— et des moyens pour tirer verticalement le ruban, de bas en haut, dans le sens de sa longueur, de façon à déposer ladite couche, la largeur de ladite surface rectangulaire étant suffisamment faible pour que le ménisque de silicium reliant le ruban aux parois de la fente soit stable, caractérisé en ce que

— la paroi (23, 24) de la fente (7) est arrondie (33) vers l'extérieur, du côté de la face inférieure (16) du fond (15),

— la longueur des segments (23, 24) est égale à la largeur du ruban (9)

— et le profil horizontal de la fente (7) comprend en outre deux courbes circulaires (26, 27) délimitant deux surfaces circulaires (28, 29) disposées respectivement aux deux extrémités de ladite surface rectangulaire (25), chacune de ces surfaces circulaires étant centrée sur l'axe longitudinal (32) de la surface rectangulaire (25), les courbes circulaires (26, 27) se raccordant avec les extrémités des segments (23, 24), de manière que les surfaces circulaires (28, 29) soient en communication avec la surface rectangulaire (25), le diamètre (34) des surfaces circulaires (28, 29) étant supérieur à la largeur (19) de ladite surface rectangulaire (25) et inférieur à une valeur limite prédéterminée correspondant au diamètre maximal capable d'assurer la stabilité du ménisque de silicium.

2. Dispositif selon la revendication 1, caractérisé en ce que le récipient (1) étant en quartz, le diamètre (34) des surfaces circulaires (28, 29) est supérieur à trois fois la largeur (19) de ladite surface rectangulaire (25).

**Claims**

1. A device for depositing a silicon layer on a carbon tape, the device comprising :
— a receptacle provided with a horizontal bottom having a slot passing therethrough, the horizontal profile of the slot comprising two parallel and facing straight line segments, said segments delimiting a rectangular area whose length corresponds to that of the segments, the tape passing through the slot in such a manner that the width of the tape is parallel to the segments,
— means for disposing a bath of liquid silicon in the receptacle,
— and means for vertically drawing the tape upwardly and lengthwise in such a manner as to deposit said layer, the width of the said rectangular area being sufficiently small for the silicon meniscus connecting the tape to the walls of the slot to be stable,
characterized in that
— the wall (23, 24) of the slot (7) flares (33) outwardly at the bottom face (16) of the bottom (15),
— the length of the segments (23, 24) is equal to the width of the tape (9),
— and that the horizontal profile of the slot (7) further includes two circular curves (26, 27) delimiting two circular areas (28, 29) disposed at a respective end of the said rectangular area (25), each of said circular areas being centered on the longitudinal axis (32) of the rectangular area (25), the circular curves (26, 27) meeting the ends of the segments (23, 24) in such a manner that the circular areas (28, 29) are in communication with the rectangular area (25), the diameter (34) of the circular areas (28, 29) being greater than the width (19) of said rectangular area (25) and less than a predetermined limit value corresponding to the maximum diameter capable of still ensuring the stability of the silicon meniscus.

2. A device according to claim 1, characterized in that the receptacle (1) being made of quartz, the diameter (34) of the circular (28, 29) is greater than three times the width (19) of said rectangular area (25).

**Patentansprüche**

1. Vorrichtung zum Beschichten eines Kohlenstoffbandes mit Silizium, bestehend aus :
— einem Behälter mit horizontalem Boden und einem durch ihn hindurchführenden Schlitz, dessen waagerechtes Profil zwei parallele einander gegenüberstehende Geradensegmente aufweist, welche eine rechtwinklige Fläche begrenzen, deren Länge der der Segmente entspricht, wobei das Band derart durch den Schlitz läuft, daß die Breite des Bandes parallel zu den Segmenten verläuft,
— Mitteln zur Bereitung eines Bades aus flüssigem Silizium im Behälter,
— und Mitteln, um das Band zur Beschichtung der Länge nach senkrecht von unten nach oben zu ziehen, wobei die Breite der rechtwinkligen Fläche genügend klein ist, um den das Band mit den Schlitzrändern verbindenden Siliziummeniskus stabil zu halten,
dadurch gekennzeichnet, daß
— die Wandung (23, 24) des Schlitzes (7) an der Unterseite (16) des Bodens (15) nach außen abgerundet (33) ist,
— die Länge der Segmente (23, 24) gleich der Breite des Bandes (9) ist
— und das horizontale Profil des Schlitzes (7) zwei kreisförmige Kurven (26, 27) umfaßt, welche zwei kreisförmige Flächen (28, 29) begrenzen, die jeweils an den Enden des rechtwinkligen Fläche (25) angeordnet sind, wobei jede der kreisförmigen Flächen auf die Längsachse (32) der rechtwinkligen Fläche (25) zentriert ist und die kreisförmigen Kurven (26, 27) an die Enden der Segmente (23, 24) derart anschließen, daß die kreisförmigen Flachen (28, 29) mit der rechtwinkligen Fläche (25) in Verbindung stehen und der Durchmesser (34) der kreisförmigen Flächen (28, 29) größer als die Breite (19) der rechtwinkligen Fläche (25), aber kleiner als ein vorbestimmter Grenzwert ist, welcher dem größten, die Stabilität des Siliziummeniskus noch gewährleistenden Durchmesser entspricht.

2. Vorrichtung nach Anspruch 1, dadurch gekennzeichnet, daß der Behälter (1) aus Quarz besteht und der Durchmesser (34) der kreisförmigen Flächen (28, 29) größer als die dreifache Breite (19) der rechtwinkligen Fläche (25) ist.

# FIG.1

FIG. 2

FIG. 3